(19) Europäisches Patentamt

European Patent Office

Office européen des brevets

(11) **EP 1 530 052 A2**

(12) **DEMANDE DE BREVET EUROPEEN**

(43) Date de publication:
**11.05.2005 Bulletin 2005/19**

(51) Int Cl.⁷: **G01R 31/02**, G01R 31/00

(21) Numéro de dépôt: **04300687.3**

(22) Date de dépôt: **18.10.2004**

(84) Etats contractants désignés:
**AT BE BG CH CY CZ DE DK EE ES FI FR GB GR
HU IE IT LI LU MC NL PL PT RO SE SI SK TR**
Etats d'extension désignés:
**AL HR LT LV MK**

(30) Priorité: **31.10.2003 FR 0312802**

(71) Demandeur: **Renault
92109 Boulogne Billancourt (FR)**

(72) Inventeurs:
- **DAGNICOURT, Emmanuel
78180, MONTIGNY LE BRETONNEUX (FR)**
- **HERMAN, Mickael
75015, PARIS (FR)**

(54) **Procédé de diagnostic des pannes physiques du réseau CAN d'un véhicule automobile**

(57) L'invention concerne un procédé de diagnostic des pannes physiques du réseau CAN HS (« High Speed » - haut vitesse) d'un véhicule automobile, sur la prise diagnostic. On branche un calculateur qui émet des trames sur les deux fils CAN-H (« High » - haur) et CAN-L (« Low » - bas) du réseau CAN HS, à destination des différents calculateurs qui y sont connectés, tel qu'il envoie une trame spécifique sur le réseau CAN HS, et mesure les tensions maximales et minimales sur chacun des deux fils CAN-H et CAN-L du réseau CAN HS pour détecter un :

- court-circuit entre ce fil CAN-H et la masse ou la batterie,

- court-circuit entre ce fil CAN-H et le fil CAN-L,
- court-circuit entre ce fil CAN-L et la masse ou la batterie,
- circuit ouvert sur le fil CAN-H ou sur le fil CAN-L,
- une perte de masse d'un calculateur.

EP 1 530 052 A2

## Description

L'invention concerne un procédé de diagnostic des pannes physiques du réseau CAN HS (« Controller Area Network; High Speed » - haute vitesse), telles que court-circuit ou circuit ouvert notamment.

Les architectures électriques et électroniques utilisées dans les véhicules automobiles actuels sont très complexes et peuvent entraîner des difficultés de diagnostic des défauts et aboutir à des surcoûts. Dans certains cas, des erreurs de diagnostic peuvent aboutir au remplacement d'une pièce non défectueuse. L'outil de diagnostic est un calculateur qu'un opérateur vient brancher sur une prise dite de diagnostic, reliée au réseau CAN HS et au réseau K quand le véhicule en est équipé. Cet outil émet une trame de diagnostic sur le réseau multiplexé uniquement -Trame Diag Mux -, qui est une requête à laquelle les différents calculateurs du véhicule, reliés par le réseau CAN, doivent répondre.

Les procédés de diagnostic actuels sont basés sur la lecture de ces trames de diagnostic du réseau - Trame Diag Mux - et la corrélation des données contenues dans la trame renvoyée par chaque calculateur du véhicule permet une localisation approximative des pannes détectées. Un calculateur considéré absent par tous les calculateurs du réseau ou seulement par une partie d'entre eux permet de conclure sur la localisation d'un circuit ouvert sur le réseau CAN HS .

Le principal inconvénient d'un tel procédé de diagnostic est qu'il ne permet pas à l'opérateur de différencier un défaut logiciel, survenant dans un des calculateurs du réseau, d'un défaut physique tel qu'un circuit ouvert sur le réseau CAN HS ou un court-circuit.

Le but de l'invention est de pallier cet inconvénient en proposant de mesurer les tensions électriques présentes dans les signaux émis sur les deux lignes High (H) et Low (L) du réseau CAN HS, en particulier les valeurs minimales et maximales afin de diagnostiquer les courts-circuits entre les fils CAN-H (« CAN High » - haut) ou CAN-L (« CAN Low » - bas) et la masse ou la batterie ainsi que les circuit ouverts sur les fils CAN-H ou L, ou bien encore la perte de masse d'un calculateur.

Pour cela, l'objet de l'invention est un procédé de diagnostic des pannes physiques du réseau CAN HS d'un véhicule automobile, sur la prise de diagnostic duquel un opérateur branche un outil de diagnostic qui émet des trames sur le réseau CAN HS, à destination des différents calculateurs qui y sont connectés, caractérisé en ce qu'il envoie une trame spécifique sur le réseau CAN HS et mesure les tensions maximales et minimales sur chacun des deux fils CAN-H et CAN-L du réseau CAN-HS, pour détecter les défauts physiques suivants :

- court-circuit entre ce fil CAN-H et la masse,
- court-circuit entre ce fil CAN-H et la batterie,
- court-circuit entre ce fil CAN-H et le fil CAN-L,
- court-circuit entre ce fil CAN-L et la masse,
- court-circuit entre ce fil CAN-L et la batterie,
- circuit ouvert sur le fil CAN-H,
- circuit ouvert sur le fil CAN-L,
- perte de masse d'un calculateur.

Selon une autre caractéristique, le procédé de diagnostic comporte les étapes suivantes :

- envoi d'une trame spécifique par l'outil de diagnostic, sur le réseau CAN HS,
- vérification que la tension de la batterie du véhicule est suffisante,
- mesure des tensions maximales et minimales sur chacun des deux fils CAN-H et CAN-L du réseau CAN HS,
- test sur la communication de la trame, émise par l'outil de diagnostic, sur le réseau CAN HS :

  o dans le cas où aucune communication n'est possible, détection des courts-circuits d'un des deux fils CAN-H ou CAN-L à la batterie, du fil CAN-H à la masse ou de l'un avec l'autre par test sur les valeurs maximales des tensions lues sur CAN-H et CAN-L,

  o dans le cas où les communications sont possibles :

- détection de court-circuit du fil CAN-H avec la batterie par test sur la tension maximale ($V_{hmax}$),
- détection de court-circuit du fil CAN-L avec la masse par test sur la tension maximale ($V_{lmax}$),
- test sur les variations de tension sur les deux fils CAN-H et CAN-L et détection d'un circuit ouvert sur le réseau CAN HS s'il n'y a pas de variation détectée,
- comparaison des variations de tension entre les deux fils CAN-H et CAN-L et, dans le cas de faibles variations de tension sur le fil CAN-L, détection d'un circuit ouvert sur CAN-L entre l'outil de diagnostic et le premier calculateur ou bien d'un court-circuit du fil CAN-L avec la masse,
- test de l'outil de diagnostic,
- détection d'une perte de masse si la tension maxi-male $V_{lmax}$ sur le fil CAN-L et la tension minimale $V_{hmin}$ sur le fil CAN-H sont supérieures à la tension moyenne $V_{com}$ ,
- détection d'un circuit ouvert sur le fil CAN-H si la tension minimale $V_{hmin}$ est inférieure à la tension moyenne $V_{com}$, la tension sur le fil CAN-L étant normale par ailleurs,
- détection d'un circuit ouvert sur le fil CAN-L si la ten-sion maximale $V_{lmax}$ est supérieure à $V_{com}$, la tension sur le fil CAN-H étant par ailleurs normale.

D'autres caractéristiques et avantages de l'invention apparaîtront à la lecture de la description d'un exemple de réalisation, illustrée par les figures suivantes qui sont :

- la figure 1 : un organigramme général des différentes étapes du procédé de diagnostic,
- la figure 2 : un organigramme détaillé dudit procédé,
- la figure 3 : un extrait d'une trame émise sur le réseau CAN HS,
- la figure 4 : différents types de courts-circuits sur le réseau CAN HS, en cas de non transmission de trame,

et en cas de transmission de trame sur le réseau CAN HS :

- la figure 5 : un exemple de court-circuit du fil CAN-H à la batterie,
- la figure 6 : un exemple de court-circuit du fil CAN-L à la masse,
- la figure 7 : un exemple de perte de masse,
- la figure 8 : un exemple de circuit-ouvert sur le fil CAN-L,
- la figure 9 : un exemple de circuit-ouvert sur le fil CAN-H.

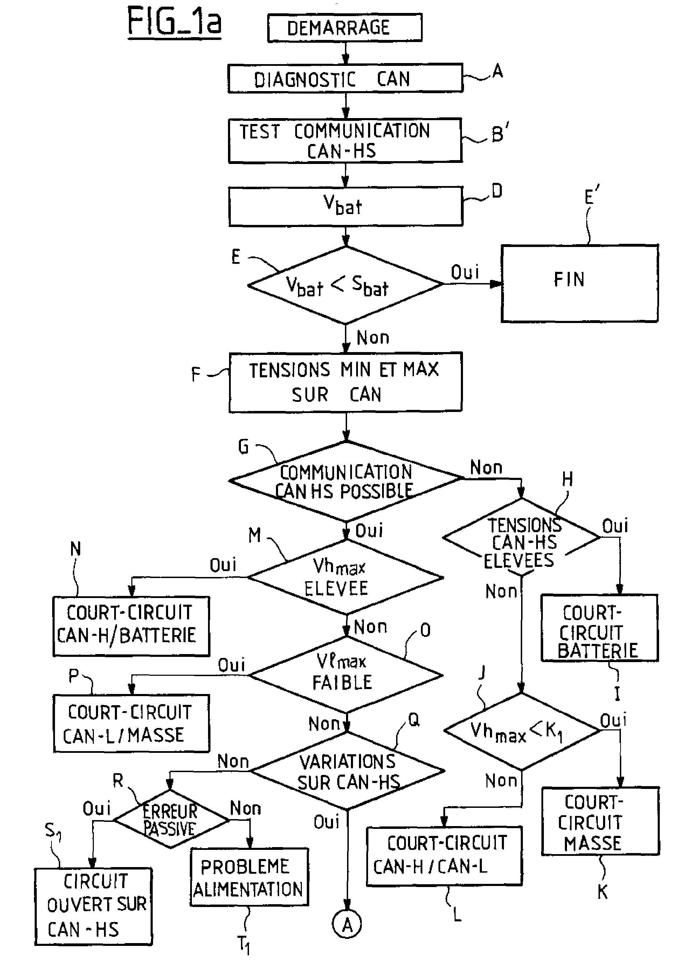

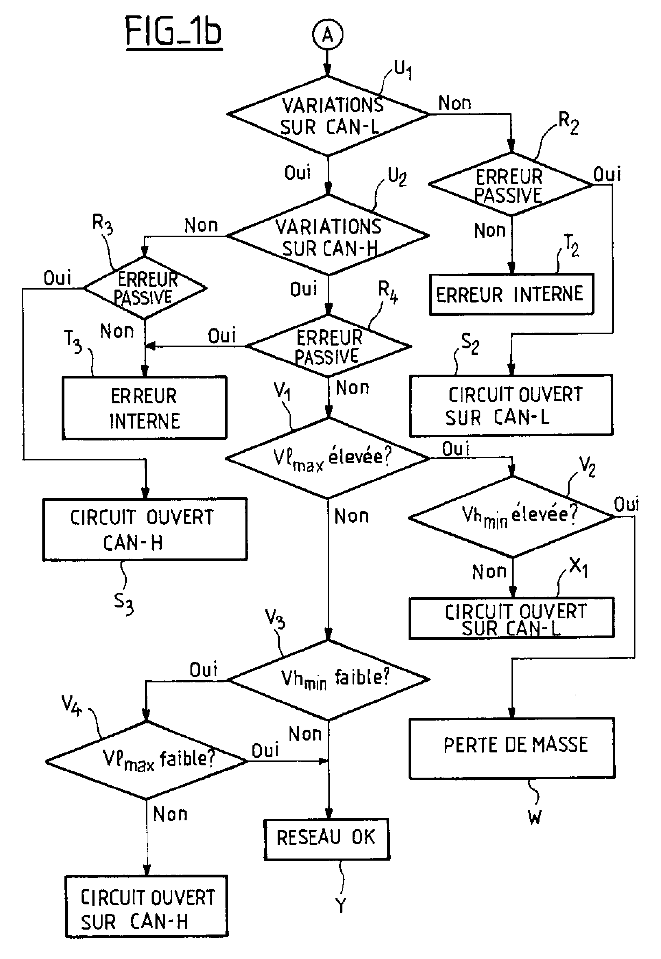

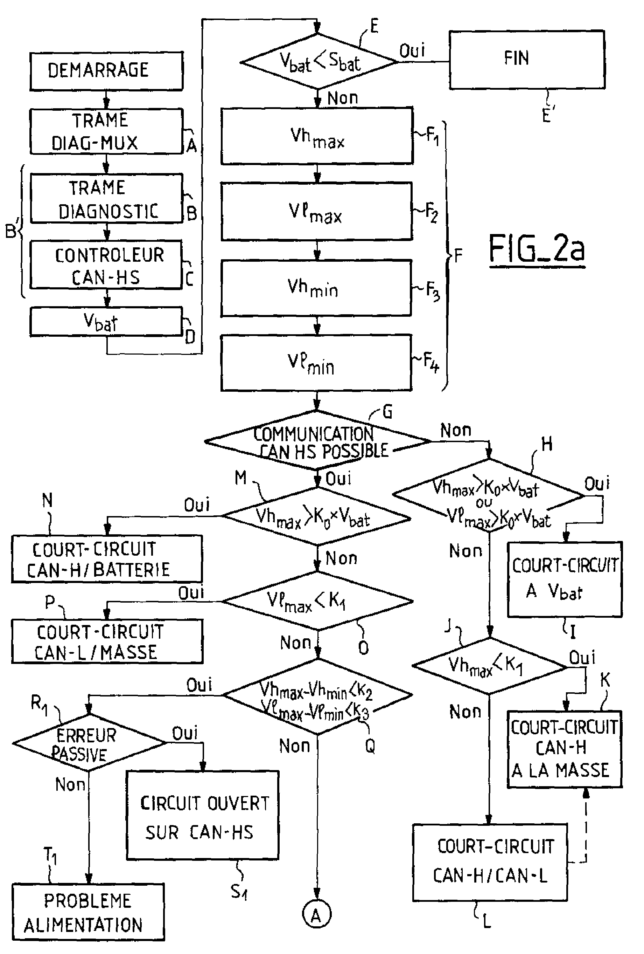

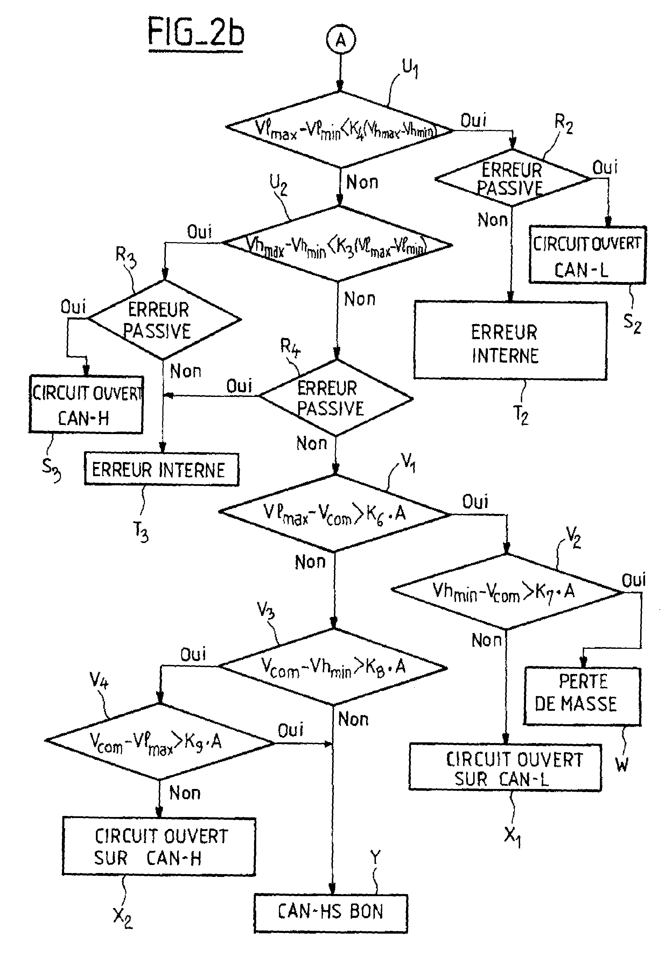

Selon un schéma général de la figure 1 divisée en deux parties figure 1a et figure 1b et détaillé de la figure 2, elle aussi divisée en deux parties figures 2a et figure 2b, le procédé de diagnostic des pannes physiques du réseau CAN HS d'un véhicule automobile comporte, après une étape de démarrage, une étape A) de diagnostic du réseau CAN multiplexé destiné à détecter d'éventuelles pannes logicielles dans les différents calculateurs électroniques du réseau. Elle comprend l'émission d'une trame Diag Mux émise soit sur les fils CAN-H et CAN-L, soit sur la ligne K du bus de diagnostic dans une autre configuration.

Elle est suivie par une étape B') de test de communication sur le réseau CAN-HS, consistant d'une part (étape B) à émettre une trame réservée à l'outil de diagnostic, comprenant un identificateur propre à cet outil que les calculateurs du réseau CAN doivent reconnaître, et d'autre part (étape C) à vérifier l'état du contrôleur du protocole CAN HS.

Une étape D) suivante prévoit la lecture de la tension de la batterie $V_{bat}$, qui est ensuite comparée à un seuil prédéfini $S_{bat}$ lors d'une étape E), ce seuil étant par exemple égal à 10 Volts. Si cette tension $V_{bat}$ est trop faible, l'algorithme est interrompu et l'opérateur devra tout d'abord recharger la batterie avant d'envisager le diagnostic des défauts du réseau CAN HS (étape E').

Par contre, si la tension $V_{bat}$ est correcte, le procédé mesure, à l'étape F), les valeurs maximales et minimales des tensions existant sur chacun des deux fils CAN-H et CAN-L du réseau CAN HS, et les mémorise. Afin de réduire à un seul le nombre de capteurs de mesure, le procédé réalise quatre étapes $F_1$ à $F_4$ de mesure de la tension maximale $V_{hmax}$ du fil CAN-H et $V_{lmax}$ du fil CAN-L, du réseau CAN HS et de la tension minimale $V_{hmin}$ du fil CAN-H et $V_{lmin}$ du fil CAN-L, pour détecter une panne parmi une liste de pannes prédéfinies, stockée dans l'outil de diagnostic, telles que :

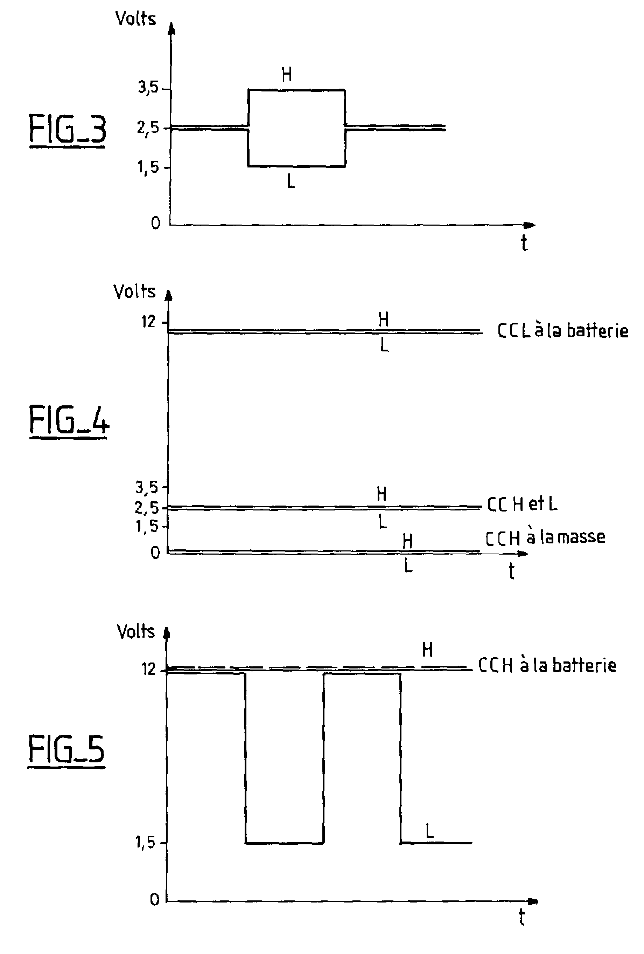

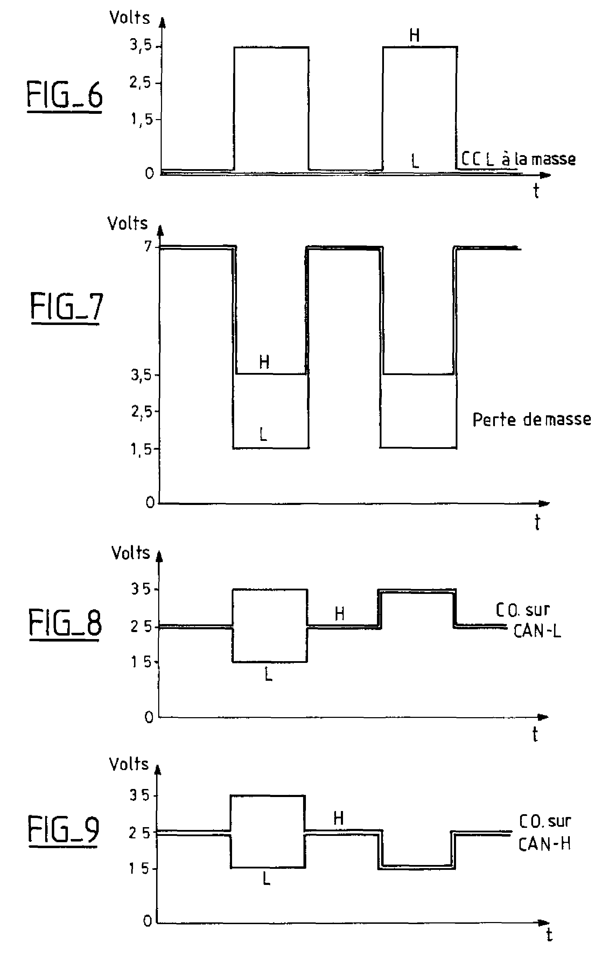

- court-circuit entre ce fil CAN-H et la masse, (figure 4)
- court-circuit entre ce fil CAN-H et la batterie, (figure 5)
- court-circuit entre ce fil CAN-H et le fil CAN-L, (figure 4)
- court-circuit entre ce fil CAN-L et la masse, (figure 6)
- court-circuit entre ce fil CAN-L et la batterie, (figure 4)
- circuit ouvert sur le fil CAN-H, (figure 9)
- circuit ouvert sur le fil CAN-L, (figure 8)
- perte de masse d'un calculateur, (figure 7).

Le procédé effectue un test fondamental à l'étape G), permettant de détecter la plupart des courtcircuits établis dans une liste de pannes stockée dans l'outil de diagnostic, telles que :

- court-circuit entre ce fil CAN-H et la masse,
- court-circuit entre ce fil CAN-H et la batterie,
- court-circuit entre ce fil CAN-H et le fil CAN-L,
- court-circuit entre ce fil CAN-L et la masse,
- court-circuit entre ce fil CAN-L et la batterie,

consistant à vérifier que la trame, émise à l'étape B) par l'outil de diagnostic et dont un extrait est représenté sur la figure 3, est bien communiquée sur le réseau CAN HS, lue par les différents calculateurs du réseau qui chacun l'acquittent vers l'outil de diagnostic.

Si la communication de cette trame est impossible, le procédé vérifie à l'étape H), que les valeurs des tensions lues sur les fils CAN-H et CAN-L du réseau CAN HS ne sont pas trop élevées puisque aucun signal de trame ne peut y circuler. Pour cela, il compare simultanément les tensions maximales $V_{hmax}$ du fil CAN-H et $V_{lmax}$ du fil CAN-L à un pourcentage de la tension de la batterie, $K_0 * V_{bat}$, qui est inférieur à la tension maximale de la trame émise. Le coefficient $K_0$ peut être égal à 0.9 par exemple. Normalement, $V_{lmax}$ est égale à 2.5 Volts et $V_{hmax}$ est égale à 3.5 Volts.

Si au moins une de ces tensions est effectivement trop élevée, c'est-à-dire que la tension maximale $V_{hmax}$ du fil CAN-H ou $V_{lmax}$ du fil CAN-L est supérieure à $K_0 * V_{bat}$, il détecte un court-circuit d'un des deux fils du réseau CAN HS avec la batterie (étape I), alors qu'aucune trame ne circule sur ces fils.

Par contre, si ces tensions ne sont pas trop élevées, le procédé vérifie, à l'étape J), si la tension sur le fil CAN-H n'est pas trop faible, ce qui signifierait un court-circuit du fil CAN-H, au moins, avec la masse (étape K). Pour cela, il compare la tension maximale $V_{hmax}$ sur le fil CAN-H à un seuil $K_1$, inférieur à la tension minimale de la trame, égal à 0.5 Volt par exemple. Normalement, $V_{lmin}$ est égale à 1.5 Volts et $V_{hmin}$ est égale à

2.5 Volts, donc si la tension maximale $V_{hmax}$ est inférieure à $K_1$, il y a un court-circuit.

Dans le cas contraire, l'absence de tensions trop élevées ou trop faibles sur le réseau CAN HS, alors qu'il n'y a pas de communication de trames, signifie un court-circuit des deux fils entre eux (étape L).

Ces différents court-circuits apparaissent sur la figure 4, qui représente les valeurs des tensions sur les fils CAN-H et CAN-L du réseau CAN HS.

Si la communication de la trame propre à l'outil de diagnostic, émise à l'étape B) est possible, l'étape M) du procédé vérifie que la tension maximale lue sur le fil CAN-H du réseau CAN HS n'est pas trop élevée, ce qui signifierait la présence d'un court-circuit du fil CAN-H du réseau CAN HS avec la batterie (étape N). Il compare donc la tension maximale $V_{hmax}$ sur le fil H à $K_0 * V_{bat}$, le coefficient $K_0$ étant le même qu'à l'étape H) et conclut à un court-circuit avec la batterie si $V_{hmax}$ est supérieure à $K_0 * V_{bat}$. Un tel court-circuit est représenté sur la figure 5.

Puis, le procédé vérifie à l'étape O) que la tension maximale lue sur le fil CAN-L du réseau CAN HS n'est pas trop faible, ce qui signifierait un court-circuit de ce fil avec la masse (étape P), représenté sur la figure 6. Il compare donc la tension maximale $V_{lmax}$ sur le fil CAN-L à $K_1 * V_{bat}$, le coefficient $K_1$ étant le même qu'à l'étape J) et si $V_{lmax}$ est inférieure à $K_1 * V_{bat}$, il conclut à un court-circuit avec la masse.

Après ces deux tests, le procédé considère les variations de tension sur le réseau CAN HS, à l'étape Q), notamment en comparant à la fois la différence entre les valeurs maximale et minimale de la tension sur le fil CAN-H à un seuil $K_2$ et celle entre les valeurs maximale et minimale de la tension sur le fil CAN-L à un seuil $K_3$, ces seuils étant égaux à 0.2 Volt par exemple. Ces seuils de tension sont de valeurs très inférieures à la tension minimale de la trame émise sur le fil CAN-L. S'il constate qu'il n'y a pas de variation, il teste l'état du contrôleur de l'outil de diagnostic qui a émis la trame (étape $R_1$). Si le contrôleur de l'outil de diagnostic est en erreur passive, cela signifie que les messages envoyés par l'outil de diagnostic ne sont pas acquittés par les différents calculateurs du réseau et donc que la panne est due à un circuit ouvert sur le réseau CAN HS, entre l'outil de diagnostic et le premier calculateur du réseau (étape Si), ou bien au fait que le véhicule n'est pas équipé d'un réseau CAN HS. Sinon, les calculateurs acquittent bien la trame sur le réseau CAN HS, mais il s'agit d'un problème d'alimentation, l'opérateur ayant par exemple oublié de mettre le contact du véhicule (étape $T_1$).

S'il y a des variations de tensions sur le réseau CAN HS, le procédé vérifie si les variations entre les tensions extrêmes sur le fil CAN-L sont inférieures à celles sur le fil CAN-H (étape $U_1$). Par exemple, il compare la différence entre les tensions maximale et minimale sur le fil CAN-L à un pourcentage $K_4$ de la différence entre les tensions maximale et minimale sur le fil H :

$$( V_{lmax} - V_{lmin} ) < K_4 * ( V_{hmax} - V_{hmin} )$$

avec le coefficient $K_4$ pouvant être égal à 0,15 par exemple.

S'il n'y a pas de variation de tension sur le fil CAN-L, le calculateur effectue le test du contrôleur (étape $R_2$). Si le contrôleur de l'outil de diagnostic est en erreur passive, la panne provient d'un circuit ouvert sur le fil CAN-L du réseau CAN HS (figure 8), entre l'outil de diagnostic et le premier calculateur du réseau (étape $S_2$). Sinon, la panne détectée est double, c'est-à-dire un court-circuit entre ce fil CAN-L et la masse, avec un écart de masse dû au vieillissement, ou bien il s'agit d'une panne de l'outil de diagnostic (étape $T_2$).

Si les variations de tension constatées sur le fil CAN-L ne sont pas inférieures à celles sur le fil CAN-H, le procédé vérifie l'inverse, c'est-à-dire si les variations de tension constatées sur le fil CAN-H ne sont pas inférieures à celles sur le fil CAN-L (étape $U_2$). Si tel est le cas, et si le contrôleur de l'outil de diagnostic est en erreur passive (étape $R_3$), la panne détectée est due à un circuit ouvert du réseau entre la prise de l'outil de diagnostic OBD et le premier calculateur du réseau (étape $S_3$). Sinon, il s'agit d'une erreur interne à l'outil de diagnostic (étape $T_3$).

Dans le cas où il y a des variations normales de tension constatées sur chacun des deux fils CAN-H et CAN-L du réseau CAN HS, le procédé teste le contrôleur de l'outil de diagnostic seul à l'étape $R_4$). Etant donné qu'il a émis une trame, si celle-ci n'est pas acquittée, il y a erreur passive et le procédé déduit une panne interne (étape $T_3$). Sinon il poursuit par un test sur la tension maximale du fil CAN-L à l'étape $V_1$).

Cette tension $V_{lmax}$ est comparée à la valeur moyenne $V_{com}$ des tensions extrêmes des deux fils CAN-H et CAN-L lues sur le réseau CAN HS, $V_{com}$ étant donc égale à la moitié de la somme de la tension maximale $V_{hmax}$ sur le fil CAN-H et de la tension minimale $V_{lmin}$ sur le fil CAN-L, soit 2.5 Volts :

$$V_{com} = \tfrac{1}{2} (V_{hmax} + V_{lmin})$$

A l'étape $V_1$), la tension maximale $V_{lmax}$ sur le fil CAN-L est donc comparée à la valeur moyenne $V_{com}$ des tensions extrêmes $V_{hmax}$ et $V_{lmin}$ des deux fils H et L lues sur le réseau CAN HS. Pour cela le procédé compare la différence entre ces deux tensions $V_{lmax}$ et $V_{com}$ à un pourcentage $K_6$ de l'amplitude A entre ces tensions extrêmes $V_{hmax}$ et $V_{lmin}$, soit $K_6 * $ :

$$V_{lmax} - V_{com} > K_6 (V_{hmax} - V_{lmin})$$

Par exemple, $K_6$ est égal à 0.2.

Si cette différence est supérieure à $K_6 * $A, $V_{lmax} - V_{com} > K_6 * $A, le procédé compare, à l'étape $V_2$), la

différence entre la tension minimale $V_{hmin}$ et la moyenne $V_{com}$ à un pourcentage $K_7$ de l'amplitude A. Si cette autre différence est supérieure à $K_7*A$ :

$$V_{hmin} - V_{com} > K_7*A,$$

$$V_{hmin} - V_{com} > K_7*(V_{hmax} - V_{hmin})$$

la panne est probablement une perte de masse (étape W), et dans le cas contraire, c'est un circuit ouvert sur le fil CAN-L (étape $X_1$). Par exemple, $K_7$ est égal à 0.5.

Si à l'étape $V_1$), la différence entre ces deux tensions $V_{lmax}$ et $V_{com}$ est inférieure au pourcentage $K_6$ de l'amplitude A, le procédé, à l'étape $V_3$), compare la différence entre la tension minimale $V_{hmin}$ et la moyenne $V_{com}$ à un pourcentage $K_8$ de l'amplitude A. Si cette différence $V_{com} - V_{hmin}$ est supérieure au pourcentage $K_8*A$ de l'amplitude :

$$V_{com} - V_{hmin} > K_8*(V_{hmax} - V_{lmin})$$

$$V_{com} - V_{hmin} > K_8*A,$$

alors le procédé compare de plus la différence entre la tension maximale $V_{lmax}$ sur le fil CAN-L et la moyenne $V_{com}$ à un pourcentage $K_9$ de l'amplitude A (étape $V_4$). Si cette différence $V_{com} - V_{lmax}$ est inférieure au pourcentage $K_9*A$ de l'amplitude A :

$$V_{com} - V_{lmax} < K_9*A,$$

la panne détectée est un circuit ouvert sur le fil CAN-H (figure 9) :

$$V_{com} - V_{lmax} < K_9* (V_{hmax} - V_{lmin})$$

Dans le cas contraire, si la différence $V_{com} - V_{lmax}$ est supérieure au pourcentage $K_9*A$ de l'amplitude A :

$$V_{com} - V_{lmax} > K_9*A,$$

alors il n'y a pas de défauts physiques identifiés sur les fils CAN-H et CAN-L du réseau CAN HS.

Si à l'étape $V_3$, la différence entre les deux tensions $V_{com}$ et $V_{hmin}$ est inférieure au pourcentage $K_8*A$ de l'amplitude, alors il n'y a pas de défauts physiques identifiés sur les fils CAN-H et CAN-L du réseau CAN HS, et ce dernier est déclaré en bon état (étape y).

Toutes les pannes détectées par les mesures de tension selon le procédé sont analysées avec les pannes logicielles détectées à l'étape A) de diagnostic du réseau CAN HS multiplexé.

L'avantage de cette invention réside dans la certitude que les défauts non détectés ne sont effectivement pas présents sur le réseau CAN-HS., ce qui évite les démontages intempestifs du câblage dans le véhicule. De plus, elle est économiquement intéressante par rapport aux solutions actuellement disponibles.

Ce procédé peut être mis en oeuvre à l'aide d'un outil informatique permettant la réalisation des étapes dudit procédé. Le procédé de l'invention peut être programmé sur un article de commerce comportant une mémoire lisible par un ordinateur, par exemple sur un CD, DVD, ou équivalent, ou sur le disque dur d'un ordinateur. Le procédé peut être enregistré sur une mémoire dudit ordinateur par téléchargement d'un réseau informatique tel comme l'Internet. Un tel programme pourra être exécuté par un ordinateur à partir dudit article de commerce ou a partir dudit réseau informatique.

**Revendications**

1. Procédé de diagnostic des pannes physiques du réseau CAN HS (« Controller Area Network, High Speed » - CAN haut vitesse) d'un véhicule automobile, sur la prise diagnostic à laquelle est branché un calculateur de diagnostic qui émet des trames sur les deux fils CAN-H (« CAN High » - haut) et CAN-L (« CAN Low » - bas) du réseau CAN HS, à destination des différents calculateurs qui y sont connectés, **caractérisé en ce qu'**il envoie une trame spécifique sur le réseau CAN HS, et mesure des tensions maximales et minimales sur chacun des deux fils CAN-H et CAN-L du réseau CAN HS pour détecter une panne physique parmi une liste de pannes prédéfinies.

2. Procédé de diagnostic selon la revendication 1, **caractérisé en ce qu'**il détecte un court-circuit d'un des deux fils CAN-H ou CAN-L du réseau CAN HS avec la batterie, qu'il y ait ou non communication d'une trame émise par l'outil de diagnostic sur le réseau CAN HS, par comparaison simultanée des tensions maximales ($V_{hmax}$) du fil CAN-H et ($V_{lmax}$) du fil CAN-L avec un pourcentage de la tension de la batterie, $K_0 * V_{bat}$ supérieur à la tension maximale de la trame émise et vérification que l'une desdites tension maximales est supérieure à $K_0 * V_{bat}$.

3. Procédé de diagnostic selon la revendication 1, **caractérisé en ce qu'**il détecte un court-circuit d'un des fils CAN-H ou CAN-L du réseau CAN HS avec la masse, qu'il y ait ou non communication d'une trame émise par l'outil de diagnostic sur le réseau CAN HS, par comparaison de la tension maximale ($V_{hmax}$) sur le fil CAN-H, respectivement ($V_{lmax}$) sur le fil CAN-L, avec un seuil de tension ($K_1$) et vérifi-

cation que ladite tension maximale ($V_{hmax}$), respectivement ($V_{lmax}$) est inférieure à ce seuil ($K_1$).

4. Procédé de diagnostic selon la revendication 1, **caractérisé en ce qu'**il détecte un court-circuit entre les deux fils CAN-H et CAN-L du réseau CAN HS si, dans le cas où il n'y a pas de communication possible d'une trame émise par l'outil de diagnostic sur le réseau CAN HS, les tensions maximales ($V_{hmax}$) et ($V_{lmax}$) sur les fils CAN-H et CAN-L sont inférieures à un pourcentage de la tension batterie, $K_0$ * $V_{bat}$, et si de plus la tension maximale ($V_{hmax}$) sur le fil CAN-H, est supérieure à un seuil minimal de tension ($K_1$).

5. Procédé de diagnostic selon la revendication 1, **caractérisé en ce qu'**il détecte un circuit-ouvert sur un des deux fils CAN-H ou CAN-L du réseau CAN HS entre l'outil de diagnostic et le premier calculateur relié au réseau CAN HS, il constate qu'il n'y a pas de variation de tension sur le réseau CAN HS et que le contrôleur de l'outil de diagnostic est en erreur passive.

6. Procédé de diagnostic selon la revendication 5, **caractérisé en ce que** pour vérifier les variations de tension sur le réseau CAN HS, il compare la différence entre les tensions maximale ($V_{hmax}$) sur le fil CAN-H, respectivement ($V_{lmax}$) sur le fil CAN-L, et minimale ($V_{hmin}$) sur le fil CAN-H, respectivement ($V_{lmin}$) sur le fil CAN-L, à un seuil ($K_2$), respectivement ($K_3$).

7. Procédé de diagnostic selon la revendication 1, **caractérisé en ce qu'**il détecte un circuit-ouvert sur l'un des deux fils CAN-H, respectivement CAN-L, du réseau CAN HS, entre l'outil de diagnostic et le premier calculateur relié au réseau CAN HS, si l'amplitude des variations de tension sur le fil CAN-L, respectivement CAN-H, est inférieure à celle des variations de tension sur le fil CAN-H, respectivement CAN-L, et que le contrôleur de l'outil de diagnostic est en erreur passive.

8. Procédé de diagnostic selon la revendication 7, **caractérisé en ce qu'**il compare la différence entre la tension maximale ($V_{lmax}$) et la tension minimale ($V_{lmin}$) sur le fil CAN-L du réseau CAN HS à un pourcentage ($K_4$) de la différence entre la tension maximale ($V_{hmax}$) et la tension minimale ($V_{hmin}$) sur le fil CAN-H et si :

$$(V_{lmax} - V_{lmin}) < K_4 * (V_{hmax} - V_{hmin})$$

il en déduit que la panne détectée est un circuit ouvert sur le fil CAN-L, entre l'outil de diagnostic et le premier calculateur relié au réseau CAN HS.

9. Procédé de diagnostic selon la revendication 7, **caractérisé en ce qu'**il compare la différence entre la tension maximale ($V_{hmax}$) et la tension minimale ($V_{hmin}$) sur le fil CAN-H du réseau CAN HS à un pourcentage ($K_3$) de la différence entre la tension maximale ($V_{lmax}$) et la tension minimale ($V_{lmin}$) sur le fil CAN-L et si :

$$(V_{hmax} - V_{hmin}) < K_3 * (V_{lmax} - V_{lmin})$$

il en déduit que la panne détectée est un circuit ouvert sur le fil H, entre l'outil de diagnostic et le premier calculateur relié au réseau CAN HS.

10. Procédé de diagnostic selon la revendication 1, **caractérisé en ce qu'**il détecte un court-circuit entre le fil CAN-L du réseau CAN HS et la masse, cette dernière présentant une valeur plus élevée que celle présente sur la prise de l'outil de diagnostic, si l'amplitude des variations de tension sur le fil CAN-L est inférieure à celles des variations sur le fil CAN-H, alors que l'outil de diagnostic fonctionne.

11. Procédé de diagnostic selon la revendication 1, **caractérisé en ce qu'**il détecte un circuit-ouvert sur le fil CAN-L du réseau CAN HS si la tension maximale ($V_{lmax}$) sur le fil CAN-L est supérieure à la valeur moyenne ($V_{com}$) des tensions extrêmes des deux fils CAN-H et CAN-L lues sur le réseau CAN-HS et si la tension minimale ($V_{hmin}$) sur le fil CAN-H est inférieure à la valeur moyenne ($V_{com}$).

12. Procédé de diagnostic selon la revendication 1, **caractérisé en ce qu'**il détecte une perte de masse si la tension maximale ($V_{lmax}$) sur le fil CAN-L du réseau CAN HS et la tension minimale ($V_{hmin}$) sur l'autre fil CAN-H sont supérieures à la valeur moyenne ($V_{com}$) des tensions extrêmes lues sur les deux fils CAN-H et CAN-L du réseau.

13. Procédé de diagnostic selon la revendication 1, **caractérisé en ce qu'**il détecte un circuit-ouvert sur le fil CAN-H du réseau CAN HS si la tension maximale ($V_{lmax}$) sur le fil CAN-L et la tension minimale ($V_{hmin}$) sur le fil CAN-H sont inférieures à la valeur moyenne ($V_{com}$) des tensions extrêmes lues sur les deux fils CAN-H et CAN-L du réseau.

14. Procédé de diagnostic selon l'une des revendications 11 à 13, **caractérisé en ce que**, pour comparer la tension maximale ($V_{lmax}$) sur le fil CAN-L du réseau CAN HS à la valeur moyenne ($V_{com}$) des tensions extrêmes lues sur les deux fils CAN-H et CAN-L du réseau, il compare la différence entre ces deux tensions ($V_{lmax}$) et ($V_{com}$) à un pourcentage ($K_6$) de l'amplitude A entre ces deux tensions extrêmes ($V_{hmax}$) et ($V_{lmin}$):

$$(V_{lmax} - V_{com}) > K_6 * (V_{hmax} - V_{lmin})$$

et pour comparer la tension minimale ($V_{hmin}$) sur le fil CAN-H à la valeur moyenne ($V_{com}$), il compare la différence entre ces deux tensions ($V_{hmin}$) et ($V_{com}$) à un pourcentage ($K_7$, $K_8$) de l'amplitude A :

$$(V_{hmin} - V_{com}) > K_7 * (V_{hmax} - V_{lmin})$$

ou

$$(V_{com} - V_{hmin}) > K_8 * (V_{hmax} - V_{lmin})$$

**15.** Procédé de diagnostic selon l'une des revendications 1 à 14, **caractérisé en ce qu'**il comporte les étapes suivantes :

- envoi d'une trame spécifique de l'outil de diagnostic, sur le réseau CAN HS,
- vérification que la tension de la batterie du véhicule est suffisante,
- mesure des tensions maximales et minimales sur chacun des deux fils CAN-H et CAN-L du réseau CAN HS,
- test sur la communication de la trame, émise par l'outil de diagnostic, sur le réseau CAN HS :

    o dans le cas où aucune communication n'est possible, détection des courts-circuits d'un des deux fils CAN-H ou CAN-L à la batterie, du fil CAN-H à la masse ou de l'un avec l'autre par test sur les valeurs maximales des tensions lues sur les fils CAN-H et CAN-L,
    o dans le cas où les communications sont possibles :

- détection de court-circuit du fil CAN-H avec la batterie par test sur la tension maximale ($V_{hmax}$),
- détection de court-circuit du fil CAN-L avec la masse par test sur la tension maximale ($V_{lmax}$),
- test sur les variations de tension sur les deux fils CAN-H et CAN-L et détection d'un circuit ouvert sur le réseau CAN HS s'il n'y a pas de variation détectée,
- comparaison des variations de tension entre les deux fils CAN-H et CAN-L et, dans le cas de faibles variations de tension sur le fil CAN-L, détection d'un circuit ouvert sur CAN-L entre l'outil de diagnostic et le premier calculateur ou bien d'un court-circuit du fil CAN-L avec la masse,
- test de l'outil de diagnostic,
- détection d'un circuit ouvert sur le fil CAN-L si

la tension maximale ($V_{lmax}$) est supérieure à la tension moyenne ($V_{com}$), la tension sur le fil CAN-H étant par ailleurs normale,

- détection d'une perte de masse si la tension maximale ($V_{lmax}$) sur le fil CAN-L et la tension minimale ($V_{hmin}$) sur le fil CAN-H sont supérieures à la tension moyenne ($V_{com}$),
- détection d'un circuit ouvert sur le fil CAN-H si la tension minimale ($V_{hmin}$) est inférieure à la tension moyenne ($V_{com}$), la tension sur le fil CAN-L étant normale par ailleurs,
- détection d'un circuit ouvert sur CAN-L si la tension max ($V_{lmax}$) est supérieure à ($V_{com}$), la tension sur CAN-H étant par ailleurs normale.

**16.** Un article de commerce comportant une mémoire lisible par un ordinateur, un programme exécutable par un ordinateur étant enregistré sur ladite mémoire pour le diagnostic des pannes physiques du réseau CAN HS (« Controller Area Network, High Speed » - CAN haut vitesse) d'un véhicule automobile, sur la prise diagnostic à laquelle est branché un calculateur de diagnostic qui émet des trames sur les deux fils CAN-H (« CAN High » - CAN haut) et CAN-L (« CAN Low » - CAN bas) du réseau CAN HS, à destination des différents calculateurs qui y sont connectés, caractérisé en ce ledit programme inclut un codage pour:

- envoyer une trame spécifique sur le réseau CAN HS, et
- mesurer des tensions maximales et minimales sur chacun des deux fils CAN-H et CAN-L du réseau CAN HS pour détecter une panne physique parmi une liste de pannes prédéfinies.

**17.** Un outil informatique programmé pour le diagnostic des pannes physiques du réseau CAN HS (« Controller Area Network, High Speed » - CAN haut vitesse) d'un véhicule automobile, utilisant des étapes du procédé selon l'une quelconque des revendications 1 à 15 ou programmé en utilisant un article de commerce selon la revendication 16.

# FIG_1a

DEMARRAGE

DIAGNOSTIC CAN — A

TEST COMMUNICATION CAN-HS — B'

$V_{bat}$ — D

E — $V_{bat} < S_{bat}$ → Oui → FIN — E'

Non

F — TENSIONS MIN ET MAX SUR CAN

G — COMMUNICATION CAN HS POSSIBLE → Non → H — TENSIONS CAN-HS ELEVEES → Oui → COURT-CIRCUIT BATTERIE

Oui

M — $Vh_{max}$ ELEVEE

N — COURT-CIRCUIT CAN-H/BATTERIE

Oui (from M to N)

Non (from H)

Non (from M)

O — $Vl_{max}$ FAIBLE

P — COURT-CIRCUIT CAN-L/MASSE

Oui (from O to P)

Non (from O)

J — $Vh_{max} < K_1$ → Oui → I → COURT-CIRCUIT MASSE — K

Non (from J) → COURT-CIRCUIT CAN-H/CAN-L — L

Q — VARIATIONS SUR CAN-HS

Non (from Q) → R — ERREUR PASSIVE

Oui (from R) → $S_1$ — CIRCUIT OUVERT SUR CAN-HS

Non (from R) → PROBLEME ALIMENTATION — $T_1$

Oui (from Q) → A

# FIG_1b

(A)

VARIATIONS SUR CAN-L $U_1$

Non → ERREUR PASSIVE $R_2$

Oui ↓

VARIATIONS SUR CAN-H $U_2$

Non → ERREUR PASSIVE $R_3$

Oui → ERREUR PASSIVE $T_2$ → ERREUR INTERNE

Non → ERREUR INTERNE $T_2$

Oui ↓ $R_4$

Oui ← ERREUR PASSIVE $R_4$

Non ↓ $S_2$

Oui ← $T_3$ ERREUR INTERNE

CIRCUIT OUVERT SUR CAN-L $S_2$

$V_1$

$VP_{max}$ élevée? → Oui

Non ↓ $V_2$

$Vh_{min}$ élevée? → Oui

Non ↓ $X_1$

CIRCUIT OUVERT CAN-H $S_3$

CIRCUIT OUVERT SUR CAN-L $X_1$

$V_3$

Oui ← $Vh_{min}$ faible?

Non ↓

$V_4$

$VP_{max}$ faible? → Oui

Non ↓

PERTE DE MASSE $W$

RESEAU OK $Y$

CIRCUIT OUVERT SUR CAN-H

FIG_2a

## FIG_2b

(A)

$V\ell_{max} - V\ell_{min} < K_4(Vh_{max} - Vh_{min})$ — $U_1$

Oui → ERREUR PASSIVE — $R_2$

Oui → CIRCUIT OUVERT CAN-L — $S_2$

Non → ERREUR INTERNE — $T_2$

Non → $Vh_{max} - Vh_{min} < K_3(V\ell_{max} - V\ell_{min})$ — $U_2$

Oui → ERREUR PASSIVE — $R_3$

Oui → CIRCUIT OUVERT CAN-H — $S_3$

Non → ERREUR INTERNE — $T_3$

Non → ERREUR PASSIVE — $R_4$

Oui → CIRCUIT OUVERT CAN-H

Non → $V\ell_{max} - V_{com} > K_6 \cdot A$ — $V_1$

Oui → $Vh_{min} - V_{com} > K_7 \cdot A$ — $V_2$

Oui → PERTE DE MASSE — W

Non → CIRCUIT OUVERT SUR CAN-L — $X_1$

Non → $V_{com} - Vh_{min} > K_8 \cdot A$ — $V_3$

Oui → $V_{com} - V\ell_{max} > K_9 \cdot A$ — $V_4$

Oui → 

Non → CIRCUIT OUVERT SUR CAN-H — $X_2$

Non → CAN-HS BON — Y

FIG_3

Volts

3,5

2,5

1,5

0

H

L

t

FIG_4

Volts

12

H

L

CCL à la batterie

3,5
2,5
1,5
0

H

L

CC H et L

H

L

CCH à la masse

t

FIG_5

Volts

12

H

CCH à la batterie

1,5

L

0

t

FIG_6

FIG_7

FIG_8

FIG_9